Europäisches Patentamt

European Patent Office

Office européen des brevets

(19)

(11) Veröffentlichungsnummer: **0 519 332 A2**

(12) ## EUROPÄISCHE PATENTANMELDUNG

(21) Anmeldenummer: **92109851.3**

(22) Anmeldetag: **11.06.92**

(51) Int. Cl.⁵: **H03K 17/22**, G05F 1/46

(30) Priorität: **21.06.91 DE 4120570**

(43) Veröffentlichungstag der Anmeldung:
**23.12.92 Patentblatt 92/52**

(84) Benannte Vertragsstaaten:
**DE ES FR GB IT**

(71) Anmelder: **SIEMENS AKTIENGESELLSCHAFT**
**Wittelsbacherplatz 2**
**W-8000 München 2(DE)**

(72) Erfinder: **Schwertlein, Frank-Lothar, Dipl.-Ing.**
**(FH)**
**Fasaneriestrasse 13**
**W-8000 München 19(DE)**

(54) **Integrierbarer Spannungsregler.**

(57) Der integrierbare Spannungsregler enthält eine RESET-Einheit mit einer eigenen Referenzspannungsquelle. Die RESET-Einheit wird gänzlich von der geregelten Ausgangsspannung des Reglers gespeist. Kurzzeitige Spannungseinbrüche der primären Versorgungsspannung führen somit zu keinem RESET-Spannungsregler.

FIG 1

EP 0 519 332 A2

Die Erfindung betrifft einen integrierbaren Spannungsregler mit einer Regeleinheit, der die zu regelnde Spannung zugeführt wird und die einen Steuereingang und einen Ausgang aufweist, an dem die geregelte Spannung abgegriffen wird, mit einer Referenzspannungseinheit, die aus der zu regelnden Spannung eine Referenzspannung erzeugt, welche der Regeleinheit zugeführt wird, mit einer RESET-Einheit, die ein RESET-Ausgangssignal erzeugt, sobald die geregelte Ausgangsspannung einen vorgegebenen Wert unterschreitet.

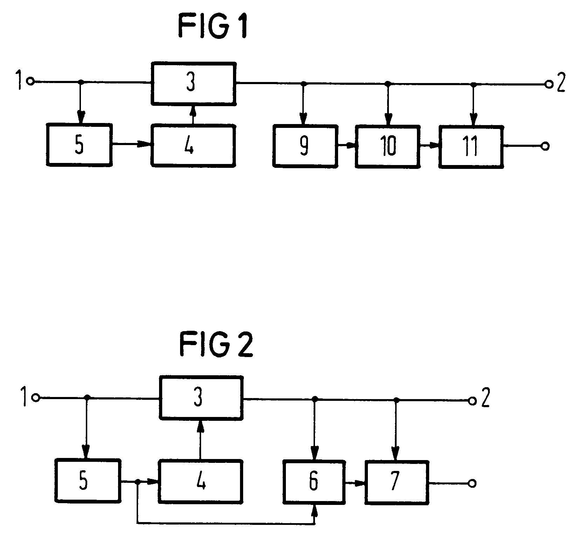

Ein derartiger Spannungsregler ist z.B. aus dem Linear Data Book 1, 1988 Edition, von National Semiconductor auf Seite 1-208 und folgende bekannt. FIG 3 auf Seite 1-213 zeigt einen detaillierten Schaltplan eines derartigen Spannungsreglers. Dieses ist in FIG 2 der Anmeldung als ein vereinfachtes Blockschaltbild dieses Spannungsreglers dargestellt.

An der Eingangsklemme 1 wird die ungeregelte Betriebsspannung $V_{IN}$ angelegt. Diese wird dem mit 3 bezeichneten Stellglied zugeführt. Das Stellglied 3 weist einen Steuereingang sowie einen Ausgang auf. Der Ausgang führt zur zweiten Anschlußklemme 2, an welchem die geregelte Betriebsspannung abgegriffen werden kann. Der Steuereingang des Stellgliedes 3 ist mit einer Regeleinheit 4 verbunden. Dieser Regeleinheit 4 wird eine Referenzspannung zugeführt, welche von einer Referenzspannungseinheit 5 erzeugt wird. Diese Referenzspannungseinheit 5 wird mit der ungeregelten Betriebsspannung 1 versorgt. Desweiteren ist eine RESET-Einheit bestehend aus einem RESET-Komparator 6 sowie einem RESET-Ausgangsverstärker 7 vorgesehen. Der RESET-Komparator 6 erhält zwei Eingangssignale, zum einen die geregelte Ausgangsspannung und zum anderen die von der Referenzeinheit 5 erzeugte Referenzspannung. Das Ausgangssignal des RESET-Komparators wird der Ausgangsstufe 7 zugeführt. Diese wird wiederum von der geregelten Ausgangsspannung versorgt. Die Ausgangsstufe 7 erzeugt ein Ausgangssignal, welches an der Klemme 8 abgreifbar ist.

Die obenbeschriebene Anordnung eignet sich insbesondere in Schaltungen mit Mikroprozessoren. Die Schaltung liefert eine geregelte Ausgangsspannung, welche z. B. 5 V beträgt. Weiterhin erzeugt sie ein RESET-Signal, welches dem Mikroprozessor sowie weiteren peripheren Schaltkreisen zugeführt werden kann. Beim Einschalten der Anordnung wird ein definiertes RESET-Signal am Ausgang 8 erzeugt, solange die Spannung am Ausgang noch keinen sicheren Betrieb der nachfolgenden Mikroprozessorschaltungen erlaubt. Die Schaltung erkennt weiterhin Einbrüche in der Betriebsspannung, aufgrund deren sie ebenfalls ein RESET-Signal erzeugt. Dabei können verschiedene Arten von Fehlern erkannt werden, wie z. B. zu niedrige Eingangsspannung, termische Überlastung, Kurzschlüsse usw.

Nachteil der obengenannten Anordnung ist, daß diese auch bei kurzen Einbrüchen der Versorgungsspannung ein RESET-Signal erzeugt. Derartige kurze Einbrüche der primär am Anschluß 1 anliegenden Betriebsspannung können bis zu einem gewissen Grad durch den sekundärseitig am Anschluß 2 angeschlossenen Lade- bzw. Glättungskondensator überbrückt werden. Trotzdem würde die in FIG 1 dargestellte Schaltungsanordnung in solchen Fällen ein RESET-Signal erzeugen.

Aufgabe der Erfindung ist es daher, einen integrierbaren Spannungsregler mit RESET-Einheit anzugeben, der nur bei Einbrüchen der geregelten Ausgangsspannung ein RESET-Signal erzeugt.

Diese Aufgabe wird durch den kennzeichnenden Teil des Anspruches 1 gelöst. Eine Weiterbildung ist Kennzeichen des Unteranspruches.

Die Erfindung wird nachfolgend anhand der FIG 1 näher erläutert. FIG 1 zeigt den erfindungsgemäßen Spannungsregler. Mit 1 und 2 sind wiederum die Ein- bzw. Ausgangsanschlüsse der Schaltung gekennzeichnet. Die Eingangsklemme 1 ist wiederum mit dem Eingang des Stellgliedes 3 verbunden. Der Ausgang des Stellgliedes 3 ist ebenfalls mit dem Ausgang 2 verschaltet. Der Regelkreis besteht, wie auch in FIG 2 dargestellt, aus der Referenzeinheit 5, welche von der ungeregelten Eingangsspannung gespeist wird, so wie der Regeleinheit 4, welche eine Referenzspannung von der Referenzspannungseinheit 5 erhält. Das Ausgangssignal der Steuereinheit 4 wird wiederum dem Steuereingang des Stellgliedes 3 zugeführt.

Unterschiedlich zum Stand der Technik, zeigt die erfindungsgemäße Schaltungsanordnung eine zweite Referenzspannungseinheit 9. Diese wird nicht von der ungeregelten an der Eingangsklemme 1 anliegenden Spannung versorgt, sondern von der am Ausgang 2 anliegenden geregelten Ausgangsspannung. Wiederum ist eine RESET-Einheit, bestehend aus einem RESET-Komparator 10 und einer RESET-Ausgangsstufe 11 vorgesehen. Das Ausgangssignal der zweiten Referenzspannungseinheit wird dem ersten Eingang des RESET-Komparators 10 zugeführt. Der zweite Eingang des RESET-Komparators 10 ist mit der geregelten Ausgangsspannung beaufschlagt. Das Ausgangssignal des RESET-Komparators 10 wird wiederum der Ausgangsstufe 11 zugeführt, diese wird wiederum von der geregelten Ausgangsspannung versorgt. Das Ausgangssignal der RESET-Ausgangsstufe wird wiederum einer Ausgangsklemme 8 zugeführt.

Die dargestellte Anordnung ermöglicht es, ein RESET-Ausgangssignal völlig unabhängig von der Eingangsspannung zu erzeugen. Die zweite Referenzspannungseinheit wird nur von der geregelten Ausgangsspannung betrieben. Kurze Einbrüche der Eingangsspannung, die von einem dem Spannungsregler nachgeschalteten Kondensator aufgefangen werden, erzeugen so keinen RESET-Impuls.

Die erfindungsgemäße Anordnung eignet sich für alle Arten von Spannungsreglern, die zusätzlich ein RESET-Signal erzeugen.

**Patentansprüche**

1. Spannungsregler mit einer Regeleinheit (3, 4), der die zu regelnde Spannung zugeführt wird und die einen Steuereingang und einen Ausgang aufweist, an dem die geregelte Spannung abgegriffen wird, mit einer Referenzspannungseinheit (5), die aus der zu regelnden Spannung eine Referenzspannung erzeugt, welche der Regeleinheit (3, 4) zugeführt wird, mit einer RESET-Einheit (10, 11), die ein RESET-Ausgangssignal erzeugt, sobald die geregelte Ausgangsspannung einen vorgegebenen Wert unterschreitet,
   **dadurch gekennzeichnet,**
   daß eine zweite Referenzspannungseinheit (9) vorgesehen ist, die aus der am Ausgang des Spannungsreglers abgreifbaren Spannung eine Referenzspannung erzeugt und diese der RESET-Einheit (10, 11) zugeführt wird.

2. Integrierbare Spannungsregler nach Anspruch 1,
   **dadurch gekennzeichnet,**
   daß die RESET-Einheit aus einem Komparator (10), und aus einer dem Komparator (10) nachgeschalteten Ausgangsstufe (11) besteht und daß dem Komparator (10) die Referenzspannung der zweiten Referenzspannungseinheit (9) und die Ausgangsspannung des Spannungsreglers zugeführt wird.

## FIG 1

## FIG 2